(19) Europäisches Patentamt
European Patent Office
Office européen des brevets

(11) Veröffentlichungsnummer: **0 196 531 B1**

# EUROPÄISCHE PATENTSCHRIFT

(12)

(45) Veröffentlichungstag der Patentschrift:
16.01.91 Patentblatt 91/03

(51) Int. Cl.⁵: **G01R 31/305**

(21) Anmeldenummer: 86103565.7

(22) Anmeldetag: 17.03.86

(54) Verfahren zur indirekten Bestimmung der Intensitätsverteilung der in einem Korpuskularstrahl-Messgerät erzeugten Korpuskularstrahlpulse.

(30) Priorität: 28.03.85 DE 3511372

(43) Veröffentlichungstag der Anmeldung:
08.10.86 Patentblatt 86/41

(45) Bekanntmachung des Hinweises auf die Patenterteilung:
16.01.91 Patentblatt 91/03

(84) Benannte Vertragsstaaten:
DE FR GB IT NL

(56) Entgegenhaltungen:
US-A- 3 857 090

(56) Entgegenhaltungen:
THE REVIEW OF SCIENTIFIC INSTRUMENTS, Band 42, Nr. 2, Februar 1971, Seiten 251-255, New York, US; G.Y. ROBINSON: "Stroboscopic scanning electron microscopy at gigahertz frequencies"
JOURNAL OF ELECTRON MICROSCOPY, Band 27, Nr. 4, 1978, Seiten 247-252, Tokyo, JP; KATSUMI URA et al.: "Picosecond pulse stroboscopic scanning electron microscope"

(73) Patentinhaber: ICT Integrated Circuit Testing Gesellschaft für Halbleiterprüftechnik mbH
Klausnerring 1a
D-8011 Heimstetten (DE)

(72) Erfinder: Plies, Erich, Dr. rer. nat.
Deisenhofener Strasse 79 c
D-8000 München 90 (DE)

(74) Vertreter: Tetzner, Volkmar, Dr.-Ing. Dr. jur.
Van-Gogh-Strasse 3
D-8000 München 71 (DE)

## Beschreibung

Die Erfindung betrifft ein Verfahren zur Bestimmung der Intensitätsverteilung der in einem Korpuskularstrahl-Meßgerät erzeugten Korpuskularstrahlpulse nach dem Oberbegriff des Patentanspruchs 1, wie zum Beispiel aus der Druckschrift The Review of Scientific Instruments (Band 42, Nr. 2, Feb. 1971, Seite 251-255) bereits bekannt ist.

Die Funktionsweise integrierter Schaltungen wird gewöhnlich mit rechnergesteuerten Testanordnungen automatisch kontrolliert. Die so durchgeführten Tests sind aber in den meisten Fällen unvollständig, da erkannte Fehler nur sehr schwer lokalisierbar sind. Deshalb müssen insbesondere während der Entwicklungsphase zusätzliche Messungen im Innern der integrierten Schaltungen durchgeführt werden. Für diese Zwecke besonders geeignet sind kontaktlos und zerstörungsfrei arbeitende Elektronenstrahl-Meßgeräte, die man zunehmend in allen Bereichen der Entwicklung und Fertigung von mikroelektronischen Bauelementen einsetzt. Die zur Zeit in der Praxis am häufigsten eingesetzten Elektronenstrahl-Meßverfahren sind beispielsweise in der Zeitschrift "Scanning", Vol.5 (1983) in den Übersichtsartikeln von H.P. Feuerbaum oder Menzel und Kubalek auf den Seiten 14 bis 24 bzw. 103 bis 122 beschrieben. Besonders aufschlußreiche Hinweise zur Lokalisierung von Fehlern in hochintegrierten Schaltungen erhält man durch quantitative Messungen des zeitlichen Potentialverlaufes an ausgewählten Knotenpunkten der zu untersuchenden Bauelemente. Hierbei wird beispielsweise der in der elektronenoptischen Säule eines modifizierten Raster-Elektronenmikroskops erzeugte Primärelektronenstrahl auf einem Meßpunkt positioniert und die vom Potential des Bauelementes abhängige Verschiebung der Energieverteilung der am Meßpunkt ausgelösten Sekundärelektronen in einem Spektrometer bestimmt. Quantitative Messungen des Potentialverlaufes mit einer Zeitauflösung im Nano-Sekundenbereich sind nur stroboskopisch nach dem Sampling-Prinzip möglich. Bei diesem aus der elektrischen Meßtechnik bekannten Verfahren wird der Primärelektronenstrahl synchron mit der Frequenz des zu messenden Signals gepulst und der Potentialverlauf durch Verschieben des Eintastzeitpunktes der Primärelektronenpulse kontinuierlich abgetastet. Die mit dieser Meßmethode erreichbare Zeitauflösung ist durch die endliche Breite der Primärelektronenpulse bestimmt. Ungestörte Messungen des zeitlichen Potentialverlaufes sind nur dann durchführbar, wenn für den Primärelektronenpuls die Form eines technisch nicht zu realisierender Dirac-Puls angenommen werden kann.

Seit Beginn des Einsatzes der Stroboskopie bzw. Sampling-Verfahren zur Messung des zeitlichen Potentialverlaufes in mikroelektronischen Bauelementen war die exakte Bestimmung der Elektronenpulsdauer äußerst problematisch. So wurde versucht, die Pulsdauer bei bekannter Pulswiederholrate aus der Reduktion des mittleren Strahlstromes bei Pulsbetrieb des Elektronenstrahl-Meßgerätes gegenüber dem Strahlstrom bei kontinuierlichen Betrieb abzuleiten. Diese Methode lieferte jedoch nur äußerst grobe Schätzwerte, da in die Rechnungen experimentell nicht überprüfbare Annahmen über die Intensitätsverteilung der Primärelektronenpulse eingehen.

Ein Verfahren zur direkten Messung der Primärelektronenpulsdauern in einem Elektronenstrahl-Meßgerät wird in der Dissertation von E. Menzel "Elektronenstrahltestsystem für die Funktionskontrolle und Fehleranalyse höchstintegrierter Schaltkreise", Universität-Gesamthochschule-Duisburg (1981) vorgeschlagen. Grundlage dieses bekannten Verfahrens ist die Transformation der zeitlichen Intensitätsverteilung der Primärelektronenpulse in eine örtliche Verteilung, die dann mit einem ortsauflösenden Nachweissystem abgetastet wird. Eine Anordnung zur Durchführung dieses Verfahrens besteht im wesentlichen aus einem zusätzlich in der Probenkammer eines Elektronenstrahl-Meßgerätes angeordneten Strahlaustastsystem mit separatem Ablenkkondensator, einer feinen Nadelspitze und einer aufwendigen Steuer- und Signalverarbeitungselektronik. Die mit dem Austastsystem erzeugten Primärelektronenpulse durchlaufen das linear ansteigende Feld des Ablenkkondensators, wobei die den Puls bildenden Elektronen entsprechend ihres zeitlichen Eintreffens im Feld des Ablenkkondensators unterschiedlich stark abgelenkt werden. Mit Hilfe der feinen Nadelspitze wird nun ein schmaler Bereich der so aus der zeitlichen Intensitätsverteilung des Primärelektronenpulses erzeugten örtlichen Intensitätsverteilung ausgeblendet, da nur die im Bereich der Nadelspitze auftreffenden Primärelektronen zum Sekundärelektronensignal beitragen. Die Aufzeichnung der Intensitätsverteilung erfolgt dann durch Variation der Verzögerungszeit zwischen der am Strahlaustastsystem anliegenden Spannung und der Spannung des Ablenkkondensators.

Dieses bekannte Verfahren zur direkten Messung der Intensitätsverteilung eines Primärelektronenpulses erfordert einen relativ großen apparativen Aufwand und eignet sich deshalb kaum für den Einsatz in einem der modifizierten Raster-Elektronenmikroskope, die vorwiegend im Rahmen der Elektronenstrahl-Meßtechnik eingesetzt werden.

Der Erfindung liegt deshalb die Aufgabe zugrunde, ein Verfahren der eingangs genannten Art anzugeben, mit dem die Intensitätsverteilung der in einem Korpuskularstrahl-Meßgerät, insbesondere in einem Elektronenstrahl-Meßgerät, erzeugten Korpuskularstrahl- bzw. Elektronenstrahlpulse indirekt bestimmt werden kann.

Dies wird erfindungsgemäß durch ein Verfahren nach dem kennzeichnenden Teil des Patentanspruchs 1 erreicht.

Der mit dem erfindungsgemäßen Verfahren erzielbare Vorteil besteht insbesondere darin, daß die Intensitätsverteilung eines Korpuskularstrahlpulses mit der nur unwesentlich erweiterten Meßkette des die Pulse erzeugenden Korpuskularstrahl-Meßgerätes gewonnen werden kann.

Die Ansprüche 2 und 3 sind auf bevorzugte Ausgestaltungen und Weiterbildungen des Verfahrens nach der Erfindung gerichtet.

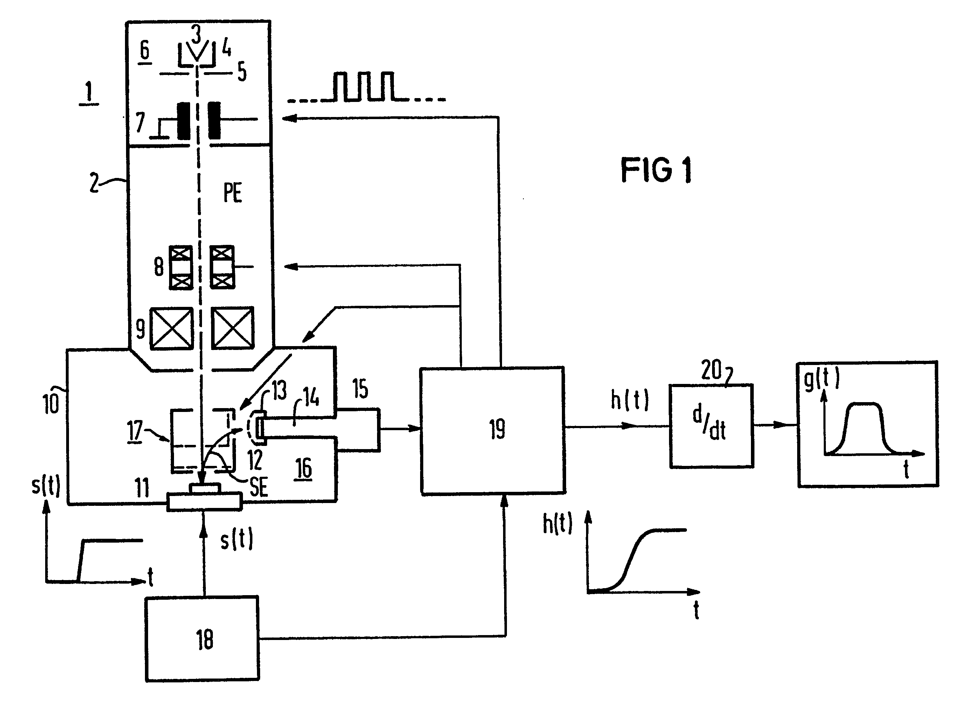

Das erfindungsgemäße Verfahren wird nachfolgend anhand des in Fig.1 dargestellten Ausführungsbeispiels einer Anordnung zur Durchführung des erfindungsgemäßen Verfahrens erläutert.

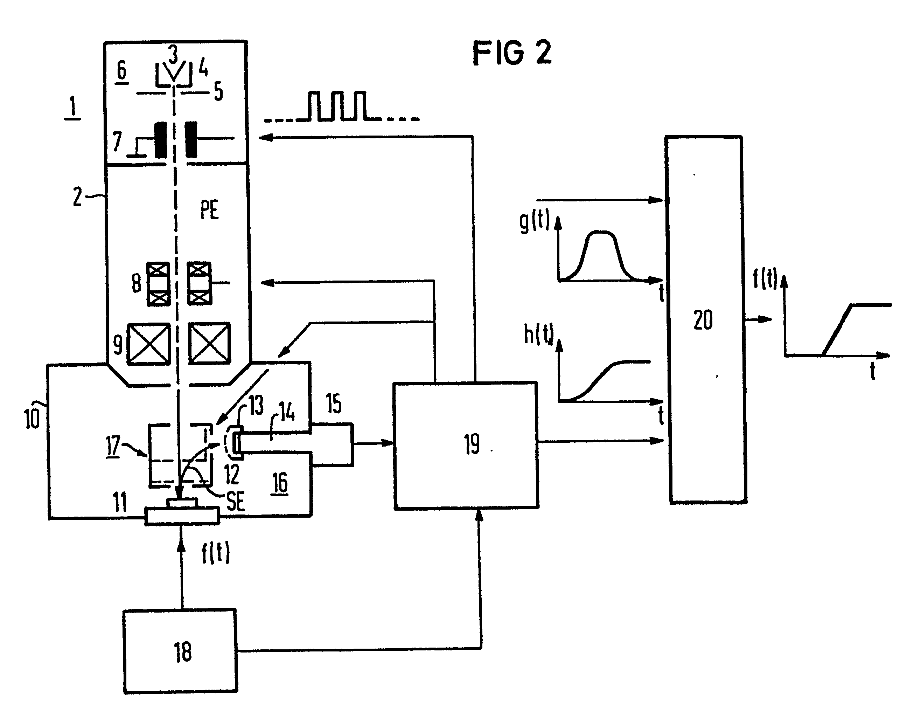

Am Beispiel der in Fig.2 dargestellten Anordnung wird erläutert, wie das erfindungsgemäße Verfahren in einem Elektronenstrahl-Meßgerät zur Verbesserung der Zeitauflösung bei quantitativen Messungen des zeitlichen Potentialverlaufes eingesetzt werden kann.

Nach dem in Fig.1 dargestellten Ausführungsbeispiel einer Anordnung zur Durchführung des erfindungsgemäßen Verfahrens wird ein feingebündelter Korpuskularstrahl, beispielsweise ein Elektronenstrahl PE in der elektronenoptischen Säule eines Elektronenstrahl-Meßgerätes 1 erzeugt. Diese Säule 2 weist neben einer Vielzahl hier nicht gezeigter magnetischer Linsen und Blenden zur Strahlformung im wesentlichen eine aus Kathode 3, Wehnelt-Elektrode 4 und Anode 5 bestehende Elektronenkanone 6, ein Strahlaustastsystem 7, ein Ablenksystem 8 und ein Linsensystem 9 zur Fokussierung des Elektronenstrahles auf. Durch geeignetes Ansteuern der Elektromagnete des Ablenksystems 8 wird der Primärelektronenstrahl auf die in einer Probenkammer 10 angeordnete Probe 11 positioniert. Außer magnetischen Ablenksystemen können auch elektrostatische Ablenksysteme eingesetzt werden. Zum Nachweis der von dem Primärelektronenstrahl PE ausgelösten Sekundärelektronen SE dient beispielsweise ein aus Abschirmgitter 12, Szintillator 13, Lichtleiter 14 und Photomultiplier 15 aufgebautes Detektorsystem 16. Diesem Detektorsystem 16 ist ein Spektrometer 17, vorzugsweise ein Gegenfeld-Spektrometer, vorgeschaltet, mit dem die vom Probenpotential abhängige Verschiebung der Energieverteilung der Sekundärelektronen bezüglich eines Referenzwertes gemessen werden kann. Hochfrequente Testsignale s(t), die man periodisch mit der Ansteuerung 18 in die Probe 11 einspeist, führen zu einem mit der Frequenz des Testsignals schwankenden Sekundärelektronensignal am Ausgang des Detektorsystems 16, das schließlich in der Meßelektronik 19 zu dem Meßsignal h(t) weiterverarbeitet wird. Zusätzlich kontrolliert und steuert die Meßelektronik 19 u.a. das Strahlaustastsystem 7 und das Ablenksystem 8, synchronisiert die Tastfrequenz der Primärelektronenpulse mit der Frequenz des an dem Bauelement anliegenden Testsignals s(t) und hält die Spannungsdifferenz zwischen der Gegenfeld-Elektrode des Spektrometers und dem Meßpunktpotential konstant. Aufbau und Wirkungsweise der Meßelektronik 19 sind beispielsweise dem in der Zeitschrift "Scanning Electron Microscopy" (1979) auf den Seiten 285-296 veröffentlichten Artikel von H.P. Feuerbaum "VLSI Testing Using the Electron Probe" zu entnehmen. Da für das erfindungsgemäße Verfahren nur das von der Meßelektronik 19 gelieferte Meßsignal h(t) von Interesse ist, braucht im folgenden nicht weiter auf die spezielle Ausführungsform dieser Anordnung eingegangen zu werden.

Mit dem in Fig.1 dargestellten Elektronenstrahl-Meßgerät 1 können zeitlich Testsignale quantitativ mit dem aus der elektrischen Meßtechnik bekannten Sampling-Verfahren gemessen werden. Hierbei wird der Primärelektronenstrahl PE auf einem Punkt der Probe 11 positioniert und das Strahlaustastsystem 7 von der Meßelektronik 19 so angesteuert, daß der Primärelektronenstrahl PE synchron mit der Wiederholfrequenz des Testsignals s(t) ein und ausgetastet wird. Der Primärelektronenstrahl PE ist also immer gerade dann eingetastet, wenn das Testsignal s(t) einen bestimmten Wert annimmt. Erst wenn das Testsignal s(t) eindeutig im Untergrundrauschen erkannt wird, verschiebt man die Phasenlage der Primärelektronenpulse PE bezüglich des Testsignals s(t), um einen neuen Meßwert aufzuzeichnen. Durch ein kontinuierliches Verschieben des Eintastzeitpunktes der Primärelektronenpulse läßt sich gesteuert von der Meßelektronik 19 der zeitliche Potentialverlauf von s(t) an einem Meßpunkt der Probe 11 abtasten und beispielsweise auf dem Bildschirm einer in Fig.1 nicht gezeigten Kathodenstrahlröhre darstellen.

Mathematisch läßt sich die quantitative Messung des zeitlichen Potentialverlaufes nach dem Sampling-Verfahren als Faltung beschreiben. Bezeichnet s(t) das von der Probenansteuerung 18 in die Probe 11 eingespeiste Testsignal, g(t) den Primärelektronenpuls und h(t) das von der aus Spektrometer 17, Detektorsystem 16 und Meßelektronik 19 bestehende Meßkette gelieferte Ausgangssignal oder Meßsignal, so sind diese Größen nach Gleichung (1) miteinander verknüpft.

$$h(t) = s(t) * g(t) := \int_{-\infty}^{+\infty} s(\tau)\, g(t-\tau)\, d\tau \qquad (1)$$

Zur indirekten Bestimmung der Intensitätsverteilung der mit dem Strahlaustastsystem 7 des in Fig.1 dargestellten Elektronenstrahl-Meßgerätes 1 erzeugten Elektronenpulse speist man als Testsignal ein in seinem Zeitverhalten bekanntes Norm-Signal s(t) mit der Ansteuerung 18 periodisch in die Probe 11 ein und tastet das Testsignal s(t) nach dem oben beschriebenen Sampling-Verfahren ab. Die Zeitabhängigkeit dieses Norm-Signals s(t) wurde vorab beispielsweise in einem handelsüblichen SamplingOszilloskop mit hoher Zeitauflösung gemessen. Besonders vorteilhaft als Normsignal s(t) sind stufenförmige Spannungspulse mit steilen Anstiegsflanken und einer im Vergleich zur Primärelektronenpulsdauer kurzen Anstiegszeit. Im Idealfall einer Stufenfunktion (heaviside-Funktion) mit $\delta$ (t) = 0 für Zeiten t kleiner Null und $\delta$(t) = 1 für Zeiten t größer Null entspräche dann das aufgezeichnete Meßsignal h(t) der Stoßantwort der aus Spektrometer 17, Detektorsystem 16 und Meßelektronik 19 gebildeten Meßkette. Wird für das in die Probe eingespeiste Norm-Signal s(t) eine ideale Stufenfunktion $\delta$(t) angenommen, so sind das nach dem Sampling-Prinzip gewonnene Meßsignal h(t) und der Primärelektronenpuls g(t) nach Gleichung (2) miteinander verknüpft.

$$h(t) = s(t) * g(t) = \int_{0}^{t} g(\tau)\, d\tau \qquad (2)$$

Hieraus ergibt sich unmittelbar die zu Gleichung (2) äquivelente Aussage :

$$g(t) = \frac{d}{dt}\, h(t) \qquad (3)$$

Dies bedeutet, daß die Intensitätsverteilung des Primärelektronenpulses g(t) durch einfaches Differenzieren des von der Meßanordnung nach dem Sampling-Prinzip aufgezeichneten Meßsignals h(t) gewonnen werden kann, falls die Primärelektronenpulsdauer groß im Vergleich zur Flankenanstiegszeit des periodisch in die Probe 11 eingespeisten Stufensignals s(t) ist.

Die Durchführung dieser mathematischen Operation erfolgt mit Hilfe des in Fig.1 dargestellten Differenziergliedes 20, an dessen Ausgang die indirekt bestimmte Intensitätsverteilung der Primärelektronenpulse abgegriffen und auf einer in Fig.1 nicht dargestellten Ausgabeeinheit ausgegeben werden kann.

Das erfindungsgemäße Verfahren ist selbstverständlich nicht auf die Verwendung eines Stufensignals als Norm-Signal s(t) beschränkt, sondern kann prinzipiell mit jedem beliebigen Signal durchgeführt werden, dessen zeitlicher Verlauf bekannt ist. Allerdings ergibt sich dann die Intensitätsverteilung der Primärelektronenpulse g(t) nicht mehr einfach durch Differenzieren des Meßsignals h(t), sondern muß vielmehr nach Gleichung (1) numerisch durch Entfaltung berechnet werden. Erheblich vereinfacht wird dieses Problem durch Anwendung des Faltungstheorems, demzufolge einer Faltung im Zeitbereich eine Multiplikation im Frequenzbereich entspricht. Im Frequenzbereich nimmt Gleichung (1) daher folgende Form an :

$$H(\nu) = G(\nu) \cdot S(\nu) \qquad (4)$$

wobei H(v) und S(v) die Fouriertransformierten des bekannten Meß- bzw. Norm-Signals h(t) und s(t) sind und G(v) die Fouriertransformierte des gesuchten Primärelektronenpulses g(t) bezeichnet.

Durch Division der bekannten Größen H(v) und S(v) und anschließender Rücktransformation der Funktion G(v) in den Zeitbereich erhält man den gesuchten Primärelektronenpuls g(t). Ein Rechenprogramm zur Durchführung schneller Fouriertransformationen nach dem Cooley-Tukey-Algorithmus ist beispielsweise in dem Lehrbuch von Brigham "The Fast Fourier Transform", Prentice Hall (1974) beschrieben.

Das erfindungsgemäße Verfahren ist auch in einfacher Weise zur Verbesserung der Zeitauflösung eines nach dem Sampling-Prinzip arbeitenden Korpuskularstrahl-Meßgerätes einsetzbar. Dies wird nachfolgend am Beispiel des in Fig.2 dargestellten Elektronenstrahl-Meßgerätes erläutert, wobei gleiche Bezugszeichen die gleichen Anordnungen wie in Fig.1 bezeichnen.

Eine genaue Kenntnis des Verlaufes des Probesignals f(t), beispielsweise in hochintegrierten Schaltungen, ist erforderlich, um schon frühzeitig während der Entwicklungsphase Schwachstellen und Konstruktionsfehler innerhalb der Halbleiterbauelemente durch Vergleich gemessener und theoretisch erwarteter Spannungswerte erkennen und beseitigen zu können. Da die maximal mögliche Zeitauflösung von der Pulsdauer des Primärelektronenpulses g(t) abhängt, ist die Güte des nach dem Sampling-Verfahren aufgezeichneten Potentialverlaufes von h(t) im wesentlichen durch die Leistungsfähigkeit des Strahlaustastsystems 7 bestimmt. Überschreitet nun die Frequenz des an dem Bauelement anliegenden Probesignals f(t) eine von dem eingesetzten Austastsystem 7 abhängigen Grenzwert, kann die Primärelektronenpulsdauer gegenüber der Signalperiode nicht mehr vernachlässigt werden, was unmittelbar zu Verfälschungen des gemessenen Signals h(t) gegenüber dem tatsächlichen Probesignal f(t) führt. Neben den durch die endliche Primärelektronenpulsdauer verursachten Verfälschungen treten auch in der aus Spektrometer 17, Detektorsystem 16 und Meßelektronik 19 aufgebauten Meßkette zusätzliche, die Zeitauflösung weiter verschlechternde Veränderungen auf. Nach Gleichung (5)

$$h(t) = f(t) * g(t) := \int_{-\infty}^{+\infty} f(\tau)\ g(t-\tau)\ d\tau\ , \qquad (5)$$

die den allgemeinen Zusammenhang zwischen Probensignal f(t), Primärelektronenpuls g(t) und Meßsignal h(t) bei Messungen des zeitlichen Signalverlaufes nach dem Sampling-Verfahren beschreibt, kann das gesuchte ungestörte Probesignal f(t) aus dem von der Meßelektronik 19 aufgezeichneten verfälschten Meßsignal h(t) durch Entfaltung rekonstruiert werden, falls der Primärelektronenpuls g(t) bekannt ist. Dieser kann aber vor Durchführung der Potentialmessung mit der gleichen aus Spektrometer 17, Detektorsystem 16 und Meßelektronik 19 aufgebauten Meßkette nach dem erfindungsgemäßen Verfahren sehr genau bestimmt werden, so daß bei der Entfaltung neben der endlichen Dauer des Primärelektronenpulses auch die verfälschenden Einflüsse der Meßkette berücksichtigt werden. Die Entfaltung des von der Meßkette gelieferten Meßsignals h(t) erfolgt beispielsweise numerisch unter Anwendung des Faltungstheorems, demzufolge einer Faltung im Zeitbereich eine Multiplikation im Frequenzbereich entspricht. Über die Beziehung

$$F(\nu) = H(\nu)\ /\ G(\nu) \qquad\qquad (6)$$

kann durch eine inverse Fouriertransformation der Größe F(v) die Zeitabhängigkeit des zu messenden Probenpotentials f(t) aus dem Meßsignal h(t) und dem bekannten Primärelektronenpuls g(t) bzw. deren Fouriertransformierten H(v) und G(v) bestimmt werden. Diese numerisch recht aufwendigen Rechnungen werden vorteilhafterweise in einem Rechner 20 durchgeführt. Ein nach dem Cooley-Tukey-Algorithmus arbeitendes FORTRAN-Programm zur Durchführung schneller Fouriertransformation ist beispielsweise dem schon erwähnten Lehrbuch von Brigham zu entnehmen.

## Ansprüche

1. Verfahren zur Verwendung eines KorpuskularstrahlMeßgerätes, bei dem

a) ein in seiner Zeitabhängigkeit bekanntes Testsignal s(t) periodisch an einen Meßpunkt einer Probe (11) angelegt wird,

b) ein mit Hilfe eines Strahlaustastsystems (7) des Korpuskularstrahl-Meßgerätes gepulster Primärkorpuskularstrahl auf den Meßpunkt der Probe (11) positioniert und synchron mit dem Testsinal s(t) eingetastet wird,

c) durch Verschiebung des Eintastzeitpunktes des Primärkorpuskularstrahles der zeitliche Potentialverlauf des Testsignales s(t) stroboskopisch nach dem Sampling-Prinzip abgetastet wird

d) und die am Meßpunkt ausgelösten Sekundärkorpuskeln in einem Detektorsystem (16) nachgewiesen werden und hieraus ein in seiner Zeitabhängigkeit bekanntes Meßsignal h(t) abgeleitet wird, dadurch gekennzeichnet, daß

e) die Intensitätsverteilung g(t) der Pulse des Primärkorpuskularstrahles durch Entfaltung des Meßsignales h(t) unter Berücksichtigung des Testsignales s(t) bestimmt wird.

2. Verfahren nach Anspruch 1, dadurch gekennzeichnet, daß

f) ein stufenförmiges Testsignal s(t) mit einer im Vergleich zur Breite der Pulse des Primärkorpuskularstrahles kurzen Flankenanstiegszeit Verwendung findet und

g) die Intensitätsverteilung g(t) der Pulse des Primärkorpuskularstrahles durch Differentiation des Meßsignales h(t) bestimmt wird.

3. Verfahren nach Anspruch 1, dadurch gekennzeichnet, daß unter Berücksichtigung der nunmehr bekannten Intensitätsverteilung g(t) der Pulse des Primärkorpuskularstrahles die Zeitabhängigkeit eines an einem Meßpunkt der Probe (11) anliegenden Probesignales f(t) durch Entfaltung des diesem Probesignal f(t) zugeordneten Meßsignales h(t) bestimmt wird.

## Claims

1. Method of using a corpuscular beam measuring device, in which

a) a test signal s(t) in respect of which the time dependence is known is applied periodically to a measuring point on a sample (11),

b) a primary corpuscular beam which is pulsed with the aid of a beam blanking system (71) of the corpuscular beam measuring device is positioned on the measurement point of the sample (11) and cut in synchronously with the test signal s(t),

c) by shifting the cut-in time of the primary corpuscular beam the potential development of the test signal s(t) in terms of time is scanned stroboscopically according to the sampling principle

d) and the secondary corpuscles released at the measuring point are detected in a detector system (161) and from them a measurement signal h(t) in respect of which the time dependence is known is derived,

characterised in that

e) the intensity distribution g(t) of the pulses of the primary corpuscular beam is determined by evolution of the measurement signal h(t) taking account of the test signal s(t)

2. Method as claimed in claim 1, characterised in that

f) a stepped test signal s(t) is used which has a short flank rise time in comparison with the width of the pulses of the primary corpuscular beam and

g) the intensity distribution g(t) of the pulses of the primary corpuscular beam is determined by differentiation of the measurement signal h(t).

3. Method as claimed in claim 1, characterised in that taking account of the intensity distribution g(t), which is now known, of the pulses of the primary corpuscular beam the time dependence of a sample signal f(t) applied to a measurement point on the sample (11) is determined by evolution of the measurement signal h(t) co-ordinated with this sample signal f(t).

## Revendications

1. Procédé d'utilisation d'un appareil de mesure à rayon corpusculaire, suivant lequel :

a) un signal de référence s(t), dont la temporisation est connue, est appliqué périodiquement en un point de mesure d'un échantillon (11),

b) un rayon corpusculaire primaire pulsé à l'aide d'un système de suppression (7) de l'appareil de mesure à rayon corpusculaire est positionné sur le point de mesure de l'échantillon (11) et introduit en synchronisme avec le signal de référence s(t),

c) la variation dans le temps du potentiel du signal de référence s(t) est analysée par stroboscopie d'après le principe d'échantillonnage par décalage de l'instant d'entrée du rayon corpusculaire primaire,

d) et les corpuscules secondaires détachés au point de mesure sont identifiés dans un système de détection (16) et un signal de mesure h(t), dont la temporisation est connue, en est déduit, caractérisé en ce que :

e) la répartition d'intensité g(t) des impulsions du rayon corpusculaire primaire se détermine par déconvolution du signal de mesure h(t), compte tenu du signal de référence s(t).

2. Procédé selon la revendication 1, caractérisé en ce que :

f) le signal de référence utilisé s(t) est un signal échelonné dont le temps de croissance du flanc est bref, comparé à la largeur de l'impulsion du rayon corpusculaire primaire, et

g) la répartition d'intensité g(t) des pulsions du rayon corpusculaire primaire se détermine par différentiation du signal de mesure h(t).

3. Procédé selon la revendication 1, caractérisé en ce que la temporisation d'un signal de référence f(t) appliqué en un point de mesure de l'échantillon (11) se détermine par déconvolution du signal de mesure h(t) affecté à ce signal de référence f(t) en tenant compte de la répartition d'intensité g(t), maintenant connue, des impulsions du rayon corpusculaire primaire.

FIG 1

# FIG 2

EP 0 196 531 B1